(19) Europäisches Patentamt
European Patent Office
Office européen des brevets

(11) Numéro de publication: **0 251 865 B1**

# (12) FASCICULE DE BREVET EUROPEEN

(45) Date de publication du fascicule du brevet: **25.04.90**

(51) Int. Cl.⁴: **G01V 1/20**, H03F 3/70

(21) Numéro de dépôt: **87401383.2**

(22) Date de dépôt: **19.06.87**

(54) **Procédé et dispositif pour améliorer la sensibilité et le rapport du signal au bruit de transducteurs piézo-électriques comportant une pluralité de capteurs combinés en parallèle.**

(30) Priorité: **23.06.86 FR 8609170**

(43) Date de publication de la demande:
**07.01.88 Bulletin 88/1**

(45) Mention de la délivrance du brevet:
**25.04.90 Bulletin 90/17**

(84) Etats contractants désignés:
**BE DE GB IT NL**

(73) Titulaire: **INSTITUT FRANCAIS DU PETROLE, 4, Avenue de Bois-Préau, F-92502 Rueil-Malmaison(FR)**

(72) Inventeur: **Beauducel, Claude, 8, rue Talon, F-69110 Henonville(FR)**
Inventeur: **Gautier, Thierry, 54, quai Maréchal Joffre, F-77000 Melun(FR)**

(56) Documents cités:
**FR-A- 2 145 099**
**US-A- 3 435 409**
**US-A- 3 940 678**
**US-A- 4 543 536**

**JOURNAL OF THE ACOUSTICAL SOCIETY OF AMERICA, vol. 61, no. 6, juin 1977, pages 1471-1476, Acoustical Society of America, New York, US; J.W. YOUNG: "Optimization of acoustic receiver noise performance**
**REVUE DE PHYSIQUE APPLIQUEE, vol. 20, no. 7, juillet 1985, pages 465-482, Les Ulis, Cedex, FR; F. BAILLIEU et al.: "L'amplificateur CMOS dans les circuits à capacités commutées"**
**1982 INTERNATIONAL SYMPOSIUM ON CIRCUITS AND SYSTEMS, Rome, 10-12 mai,**

(56) Documents cités: (suite)
**vol. 3 des 3, pages 737-740, IEEE, New York, US; A. LIBERATORE et al.: "On the synthesis of passive switched capacitor low pass filters"**

EP 0 251 865 B1

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

ACTORUM AG

**Description**

L'invention a pour objet un procédé pour améliorer la sensibilité et le rapport du signal au bruit de transducteurs piézo-électriques comportant une pluralité de capteurs combinés en parallèle.

Dans le domaine de la prospection sismique, on utilise généralement des dispositifs de réception constitués d'un nombre souvent élevé de récepteurs sismiques disposés à distance les uns des autres et connectés à un laboratoire central d'enregistrement. Chaque récepteur comporte un capteur élémentaire ou plusieurs capteurs interconnectés en série et/ou en parallèle pour accroître leur sensibilité en tension ou en charge respectivement.

Pour les applications marines, les récepteurs sont disposés tout le long d'une gaine étanche ou flûte sismique remorquée en immersion par un navire. Les capteurs couramment utilisés sont du type piézo-électrique. Ils comportent des disques de dimensions relativement faibles réalisés en un matériau piézo-électrique et associés chacun à une paire d'électrodes. Ces disques sont contenus dans des boitiers comportant une ou plusieurs faces transparentes aux ondes acoustiques.

L'ensemble des boitiers contenus dans un dispositif de réception est en général divisé en une pluralité de récepteurs, chacun d'eux comportant une pluralité de boitiers disposés à une certaine distance les uns des autres.

La combinaison des signaux électriques délivrés par un nombre relativement important de capteurs (20 à 30 par exemple) répartis à intervalles réguliers (de l'ordre de 1 m par exemple) réalise un échantillonnage en nombre d'ondes et par traitement, on obtient un filtrage d'une partie des bruits.

Il s'agit des bruits dont le nombre d'onde est inférieur à 500 cycles/km (bruits de "tirs" sismiques entre 10c/km et 20c/km, bruits acoustiques etc).

Pour les bruits dont les nombres d'onde sont plus élevés, notamment les bruits d'écoulement liés à l'avancement du navire, et aux tourbillons autour de la flûte sismique, le filtrage par traitement est impossible en raison du "repliement" du spectre de fréquence (théorème de Shannon).

Pour diminuer ces bruits en particulier ceux dont le nombre d'onde est supérieur à 5.000c/km, ce qui correspond à une longueur d'onde inférieure à 0,2 m, on peut envisager de diminuer la trainée hydrodynamique de la flûte. Mais la solution la plus efficace consiste à réaliser un capteur continu dont la longueur est supérieure à la plus grande longueur d'onde des bruits à filtrer, c'est-à-dire au moins égale à 0,2 m dans l'exemple considéré.

Par le brevet français N. 2.145.099, on connait un dispositif capteur constitué d'au moins un élément sensible comportant la combinaison d'un ruban souple en matériau piézo-électrique et de deux électrodes disposées de part et d'autre du ruban, et plus généralement de plusieurs éléments sensibles interconnectés en série par exemple, de manière à augmenter la sensibilité de l'ensemble.

Les capteurs de ce type ont en général une sensibilité assez faible, ce qui conduit à les combiner.

Comme on le verra plus en détail dans la description, la combinaison de capteurs élémentaires constitués chacun d'un élément sensible piézo-électrique associé à des électrodes et leur connexion à un amplificateur de charges électriques, permet bien d'accroître leur sensibilité et/ou le rapport du signal qu'ils délivrent aux bruits de diverses origines (S/B).

On considérera le cas des combinaisons de plusieurs capteurs en série qui ne change pas le gain procuré par le montage mais augmente sensiblement le rapport S/B.

La combinaison de plusieurs capteurs en parallèle accroît la sensibilité, on le verra, mais laisse pratiquement inchangé le rapport S/B obtenu. Le procédé selon l'invention permet d'augmenter à la fois la sensibilité d'une combinaison en parallèle d'une pluralité de capteurs élémentaires et le rapport du signal au bruit.

Il comporte la combinaison de plusieurs capteurs constitués chacun d'un élément sensible piézo-électrique associé à des électrodes et l'application des signaux engendrés par la combinaison de capteurs à un amplificateur de charges électriques, muni d'un condensateur de charge connecté en contre-réaction. Il est caractérisé en ce que l'on diminue la capacité électrique de la combinaison de capteurs à l'entrée de l'amplificateur de charges, de manière à diminuer le facteur d'amplification appliqué au bruit, sans changer celui qui est appliqué aux signaux, en connectant par des cycles successifs et en séquence un condensateur de transfert de capacité très inférieure à la capacité du condensateur de charge de l'amplificateur avec la combinaison en parallèle des capteurs, avec l'entrée de l'amplificateur, de manière à transférer séquentiellement dans ladite capacité de charge, les charges électriques accumulées par les capteurs, en réponse à des contraintes qui leur sont appliquées, et avec la masse de manière à décharger le condensateur de transfert avant toute nouvelle connexion aux capteurs.

Le dispositif de mise en oeuvre est caractérisé en ce qu'il comporte au moins une combinaison de capteurs piézo-électriques en parallèle, un amplificateur de charges associé à un condensateur de charge, au moins un condensateur de charge et au moins un commutateur électronique commandé par des moyens de synchronisation pour connecter une borne de chaque condensateur de transfert séquentiellement avec une combinaison de capteurs en parallèle, avec l'entrée dudit amplificateur de charges et avec la masse.

Le commutateur est actionné par des moyens de commande, la fréquence du signal de commutation étant choisie en fonction de la largeur de la bande passante utile aux signaux traduits par les capteurs pour réaliser un filtrage des fréquences supérieures à celles contenues dans la bande passante.

Le dispositif permet donc, non seulement d'augmenter la sensibilité et le rapport du signal au bruit, mais aussi, on le verra, de réaliser automatiquement le filtrage passe-bas qui est appliqué couramment dans toutes les chaines d'acquisition de signaux sismiques.

D'autres caractéristiques du procédé et de son dispositif de mise en oeuvre apparaîtront à la lecture de la description de modes de réalisation donnés à titre d'exemples non limitatifs, en se référant aux dessins annexés où :

- la figure 1 représente schématiquement un capteur piézo-électrique associé à un amplificateur de charges,
- la figure 2 représente une combinaison en série de capteurs connectés à l'entrée d'une amplificateur de charges,
- la figure 3 représente une combinaison en parallèle de plusieurs capteurs aux bornes d'entrée d'un amplificateur de charges,
- la figure 4 représente un premier mode de réalisation du dispositif de mise en oeuvre du procédé,
- la figure 5 représente un second mode de réalisation du dispositif de mise en oeuvre du procédé,
- la figure 6 représente une variante du second mode de réalisation du dispositif de mise en oeuvre, et
- la figure 7 représente une autre variante du second mode de réalisation, adaptée à l'amplification de charges produites par une combinaison en série.

Un capteur élémentaire constitué d'un ruban souple en matériau ayant des propriétés piézo-électriques associé à deux électrodes, est équivalent du point de vue électrique, à un générateur de tension $V_i$ en série avec une capacité $C_i$ (Fig. 1). Ce capteur est connecté à un amplificateur A pourvu en contre-réaction d'un condensateur de charge de capacité C.

Du point de vue bruit électronique, l'amplificateur est équivalent à un générateur de tension de bruit e ramenée à l'entrée. On montre que le gain en tension $G_i$ procuré par l'amplificateur A est égal à

$$-\frac{C_i}{C}$$

et que le bruit $B_S$ en sortie est dans le rapport

$$(1 + \frac{C_i}{C})$$

avec la tension de bruit e.

Pour augmenter le rapport du signal au bruit, on peut procéder à une combinaison des capteurs élémentaires en série ou en parallèle. L'application à un amplificateur A d'une combinaison en série de N capteurs élémentaires de capacité unitaire $C_i$ et délivrant chacun une tension $V_i$, procure un gain en tension identique au cas précédent

$$(G_V = -\frac{C_i}{C})$$

mais on observe que le bruit $B_S$ en sortie rapporté à la tension de bruit e à l'entrée, diminue en fonction du nombre n:

$$\frac{B_S}{e} = 1 + \frac{C_i}{nC}$$

Dans une combinaison en série, seule une fraction des charges électriques élémentaires est transférée dans la capacité C.

Si on applique à l'amplificateur A la tension délivrée par une combinaison en parallèle de N capteurs élémentaires de capacité unitaire $C_i$ et délivrant chacun une tension $V_i$, on observe que le gain en tension est multiplié par n:

$$G = \frac{V_S}{V_i} = \frac{nC_i}{C}$$

mais que le bruit augmente avec le nombre n de capteurs élémentaires:

$$\frac{B_S}{e} = 1 + \frac{nC_i}{C}$$

Le rapport du signal au bruit n'est donc pas substantiellement modifié.

Le procédé selon l'invention permet de bénéficier de l'augmentation du gain procuré par la combinaison en parallèle et d'éviter l'augmentation concomittante du bruit. La diminution de la capacité électrique de la combinaison des capteurs en parallèle est obtenue en interposant (Fig. 4) un transformateur d'impédance T dont le rapport de transformation est égal au nombre n des capteurs de la combinaison.

Le gain procuré par un tel montage est identique au précédent :

$$\frac{V_S}{V_i} = \frac{nC_i}{C}$$

mais le bruit $B_S$ en sortie est diminué :

$$\frac{B_S}{e} = 1 + \frac{C_i}{nC}$$

et correspond au bruit que l'on observe dans un montage en série.

Cette première solution est avantageuse pour certaines applications où le nombre de combinaisons de capteurs à réaliser est relativement faible, car les transformateurs d'impédance sont à la fois lourds et relativement onéreux.

Pour certaines applications, notamment pour la réalisation de flûtes sismiques marines où :

- le nombre de combinaisons de capteurs utilisées est très grand,

- la densité d'intégration de composants dans la gaine de flûte est très poussée,

- les masses et leurs répartitions ont des incidences importantes sur l'équilibre hydrodynamique durant les opérations de remorquage, le procédé selon l'invention peut encore être réalisé de la manière suivante.

La combinaison de capteurs piézo-électriques en parallèle est connectée (Fig. 5) à une première entrée $i_1$ d'un commutateur I à trois positions. Une seconde entrée $i_2$ du commutateur est connectée à l'entrée d'un amplificateur de charges A, comportant un condensateur de charge C. Une troisiéme borne $i_0$ est connectée à la masse. La borne centrale $i_3$ du commutateur I est connectée à un condensateur $C_t$ dont la capacité est très inférieure à celle du condensateur de charge C.

Un élément de synchronisation H applique au commutateur I un signal de commande réalisant séquentiellement la connexion électrique du condensateur $C_t$ avec l'ensemble des capteurs piézo-électriques, avec l'entrée de l'amplificateur A et avec la masse de manière à réaliser une suite discontinue de transferts de charges électriques des capteurs au condensateur de charge C. La connexion avec la masse réalisée cycliquement lorsque les bornes $i_0$ et $i_3$ sont interconnectées, à pour effet d'évacuer du condensateur de transfert $C_t$ la tension de bruit engendrée par l'amplificateur.

On désigne respectivement par $C_g$ et Q la capacité et la charge électrique de l'ensemble de capteurs piézo-électriques en parallèle.

Dans un premier stade, le condensateur $C_t$ reçoit de l'ensemble des capteurs une charge :

$$q_{t_1} = kQ \quad (k = \frac{C_t}{C_t + C_g})$$

qui dans le second stade, par le basculement du commutateur I, est transférée dans le commutateur C où elle développe une tension :

$$V_S = -\frac{q_{t_i}}{C}$$

ou

$$V_S = -\frac{Q}{C} \cdot \frac{C_t}{C_g + C_t} = -k\frac{Q}{C}$$

Au cours du deuxième cycle de transfert, une charge :

$$q_{t_2} = \frac{C_t}{C_t + C_g}(Q - q_{t_i})$$

qui, avec ces mêmes conventions, s'exprime encore par :

$$q_{t_2} = k(1 - k)Q$$

est transférée d'abord dans le condensateur $C_t$ puis dans le condensateur de charge C où elle développe une tension :

$$V_S = -k(1 - k)\frac{Q}{C}$$

Les cycles de transfert se poursuivant, on montre qu'au bout de n transferts, la tension $V_S$ accumulée dans le condensateur C est :

$$V_S = \frac{Q}{C}\left[1 - (1 - k)^n\right]$$

Si le nombre n est grand, la tension $V_S$ tend donc vers une limite :

$$V_{S(Lim)} = -\frac{Q}{C}$$

On réalise donc le transfert complet dans le condensateur de l'amplificateur A, de la charge électrique développée par les capteurs piézo-électriques de la combinaison E.

On montre facilement que la tension de bruit engendrée à l'issue des commutations successives, s'exprime par la relation :

$$\frac{B_S}{e} = 1 + \frac{C_t}{2C}$$

La capacité $C_t$ étant beaucoup plus petite que C, la tension de bruit est de ce fait très réduite et comparable avec celle que l'on observe avec un transformateur d'impédance.

Le transfert de charges s'effectue par des transferts successifs. Le temps nécessaire à ces transferts est défini par sa constante de temps $\tau$et l'on montre qu'elle s'exprime par la relation :

$$\tau = \frac{1}{F} \cdot \frac{1}{\mathrm{Log}\frac{1}{k}}$$

ou F représente la fréquence du signal de commande du commutateur I. Cette relation est valable dans le cas particulier où la résistance du commutateur est négligeable.

Dans la pratique où le commutateur présente une certaine impédance R, la constante de temps $\tau_R$ s'exprime par la relation :

$$\tau = \frac{I}{F} \cdot \frac{I}{\left[\mathrm{Log} \quad (1 - k) \quad (1 - \exp\frac{1}{FRkC_g})\right]} -1$$

Il convient de souligner que du fait de sa constante de temps $\tau$, le dispositif se comporte comme un filtre passe-bas dont les caractéristiques peuvent être ajustées en choisissant convenablement la valeur de la capacité $C_t$ et la fréquence d'échantillonnage F. On peut donc limiter la bande passante du signal amplifié à la largeur utile. Le dispositif remplit donc automatiquement la fonction du filtre anti-repliement (antialiasing) qui est de toute façon inclus dans toute chaine d'acquisition de données sismiques.

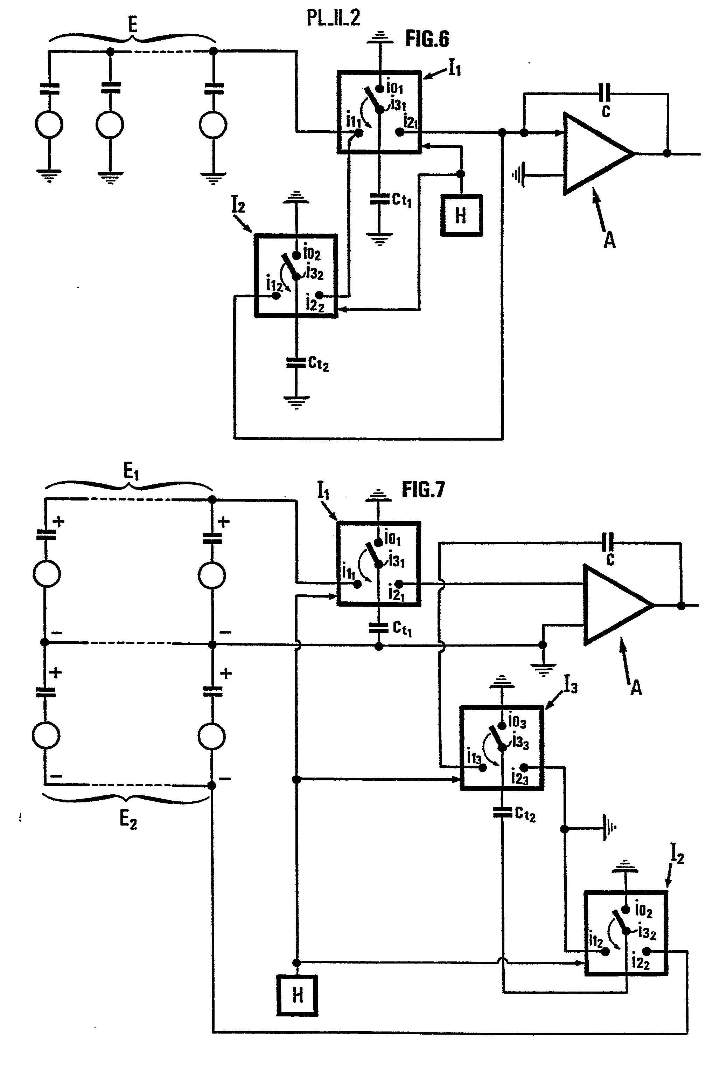

Suivant le mode de réalisation de la figure 6, on utilise deux condensateurs de transferts $C_{t1}$ et $C_{t2}$ connectés respectivement aux bornes $i_{31}$, $i_{32}$ de deux commutateurs $I_1$ et $I_2$.

La borne $i_{11}$ et la borne $i_{22}$ respectivement des commutateurs $I_1$ et $I_2$ sont connectées à l'ensemble E de capteurs piézo-électriques. La borne $i_{21}$ et la borne $i_{12}$ respectivement des commutateurs $I_1$ et $I_2$ sont connectées toutes les deux à l'entrée de l'amplificateur A. Les bornes $i_{01}$ et $i_{02}$ des deux commutateurs sont connectées à la masse. Un même élément de synchronisation H commande le basculement des commutateurs $I_1$ et $I_2$. Les bornes centrales $i_{31}$ et $i_{32}$ sont successivement connectées, la première avec $i_{11}$, $i_{21}$ et $i_{01}$ et la seconde avec $i_{12}$, $i_{22}$ et $i_{02}$.

Compte-tenu des interconnexions réalisées, il y a en permanence un condensateur de transfert $C_{t1}$ ou $C_{t2}$ qui reçoit des charges de l'ensemble de capteurs E pendant que l'autre se décharge dans le condensateur C de l'amplificateur A.

De la même façon, les tensions résiduelles de bruit sont évacuées au passage par les bornes $i_{01}$ et $i_{02}$. L'entrée de l'amplificateur A étant chargée pendant les 2/3 de chaque cycle par l'un des deux condensateurs de transfert $C_{t1}$ ou $C_{t2}$ , le niveau de bruit que l'on mesure en sortie s'exprime par la relation:

$$B_S = \frac{C_t}{2C}$$

où $C_t$ exprime la capacité commune des condensateurs $C_{t1}$ et $C_{t2}$.

La variante illustrée à la figure 7 concerne l'adaptation du système de transfert à deux condensateurs de charge, au cas où l'ensemble de capteurs comporte deux sous-ensembles $E_1$ et $E_2$ de capteurs piézo-électriques connectés en série, la borne commune des deux sous-ensembles étant connectée à la masse.

Un premier commutateur $I_1$ est adapté à connecter un premier condensateur de transfert $C_{t1}$ relié à sa borne $i_{31}$, soit avec une borne $i_{11}$, laquelle est reliée à la borne positive du sous-ensemble $E_1$, soit avec une borne $i_{21}$ laquelle est reliée à l'entrée d'un amplificateur de charges A, soit avec une borne $i_{01}$ qui est connectée à la masse.

Un second commutateur $I_2$ est adapté à connecter une première borne d'un second condensateur de transfert $C_{t2}$ (qui est reliée à sa borne centrale $i_{32}$) soit avec une seconde borne $i_{12}$ connectée à la masse, soit avec la borne négative du second sous-ensemble $E_2$ qui est connectée à une seconde borne $i_{22}$, soit encore à une troisième borne $i_{32}$ connectée à la masse.

Un troisième commutateur $I_3$ est adapté à connecter l'autre borne du second condensateur de transfert $C_{t2}$ reliée à sa borne centrale $i_{33}$, soit avec une première borne $i_{13}$, laquelle est connectée à l'entrée

de l'amplificateur A, soit avec une seconde borne $i_{23}$ connectée à la masse, soit avec une troisième borne $i_{03}$, elle aussi connectée à la masse.

Un même élément de synchronisation H commande simultanément la commutation des trois commutateurs $I_1$, $I_2$ et $I_3$ à une fréquence de commutation F.

Compte-tenu du mode de connexion réalisé, le transfert de charges électriques du premier sous-ensemble $E_1$ au premier condensateur de transfert $C_{t1}$, s'accompagne d'un transfert dans le condensateur C de l'amplificateur A, de charges accumulées par le second condensateur de transfert $C_{t2}$, le basculement simultané des trois commutateurs provoquant l'opération symétrique, celle où le premier condensateur de charges $C_{t1}$ se vide dans le condensateur de charges C et le second condensateur de transfert accumule des charges prélevées dans le second sous-ensemble $E_2$.

Une fraction de chaque cycle pendant laquelle les bornes centrales $i_{31}$, $i_{32}$, $i_{33}$ des trois commutateurs sont connectées respectivement aux bornes $i_{01}$, $i_{02}$, $i_{03}$, est utilisée pour décharger des condensateurs de transfert $C_{t1}$, $C_{t2}$, les tensions résiduelles de bruit.

Par ce mode de réalisation, on réalise par un même amplificateur, l'amplification des charges accumulées par deux groupements de capteurs piézo-électriques de polarité opposées. Là encore, la connexion quasi-permanente d'un condensateur de transfert $C_{t1}$ ou $C_{t2}$ à l'entrée de l'amplificateur, évite les bruit de commutation.

Le court-circuitage intermittent des condensateurs de transfert réalisé par l'utilisation de commutateurs à trois pôles, reste cependant une opération facultative. On ne sortirait pas du cadre de l'invention en utilisant des commutateurs à deux positions où les condensateurs de transfert sont connectés alternativement aux capteurs et à l'entrée de l'amplificateur de charges associé.

**Revendications**

1. - Procédé pour améliorer la sensibilité et le rapport du signal au bruit de transducteurs piézo-électriques comportant la combinaison de plusieurs capteurs constitués chacun d'un élément sensible piézo-électrique associé à des électrodes et l'application des signaux engendrés par la combinaison de capteurs à un amplificateur (A) de charges électriques, muni d'un condensateur de charge (C) connecté en contre-réaction, caractérisé en ce que l'on diminue la capacité électrique de la combinaison de capteurs en parallèle mesurable à l'entrée de l'amplificateur de charges, de manière à diminuer le gain d'amplification appliqué au bruit sans changer celui qui est appliqué auxdits signaux, en connectant par des cycles successifs et en séquence un condensateur de transfert ($C_t$) de capacité très inférieure à la capacité du condensateur de charge (C) de l'amplificateur (A) avec la combinaison en parallèle des capteurs, avec l'entrée de l'amplificateur, de manière à transférer séquentiellement dans ladite capacité de charge (C), les charges électriques accumulées par les capteurs, en réponse à des contraintes qui leur sont appliquées, et avec la masse de manière à décharger le condensateur de transfert avant toute nouvelle connexion auxdits capteurs.

2. - Dispositif pour la mise en oeuvre du procédé selon la revendication 1, caractérisé en ce qu'il comporte au moins une combinaison de capteurs piézo-électriques en parallèle, au moins un amplificateur de charges (A) associé à un condensateur de charge (C), au moins un condensateur de transfert ($C_t$) de capacité très inférieure à la capacité du condensateur de charge (C) et au moins un commutateur électronique (I) commandé par des moyens de synchronisation pour connecter une borne de chaque condensateur de transfert ($C_t$) séquentiellement avec une combinaison de capteurs en parallèle, avec l'entrée dudit amplificateur de charges et avec la masse.

3. - Dispositif selon la revendication 2, caractérisé en ce que les moyens de synchronisation comportant un oscillateur d'horloge (H) émettant un signal de commutation dont la fréquence (F) est choisie en fonction de la largeur de la bande passante utile des signaux reçus par lesdits capteurs, pour réaliser un filtrage des fréquences supérieures à celles contenues dans la bande passante.

4. - Dispositif selon la revendication 2, caractérisé en ce qu'il comporte deux condensateurs de transfert ($C_{t1}$, $C_{t2}$) ayant chacune une première borne connectée en permanence à la masse et deux commutateurs électroniques ($I_1$ $I_2$), et en ce que les moyens de synchronisation (H) sont connectés pour appliquer aux commutateurs ($I_1$, $I_2$) un signal de commande de manière que les secondes bornes des deux condensateurs de transfert ($C_{t1}$, $C_{t2}$) soient connectées en séquence et alternativement avec la combinaison de capteurs pour l'un et avec l'entrée de l'amplificateur de charges (A) pour l'autre.

5. - Dispositif selon la revendication 2, caractérisé en ce que la combinaison de capteurs comprend deux sous-ensembles ($E_1$, $E_2$) de capteurs en parallèle, les deux sous-ensembles étant interconnectés en série avec leurs bornes communes connectées à la masse, et en ce qu'il comporte deux condensateurs de transfert ($C_{t1}$, $C_{t2}$) et trois commutateurs électroniques ($I_1$, $I_2$, $I_3$) agencés pour que le premier condensateur ($C_{t1}$) ait une première borne connectée en permanence à la masse et une seconde borne connectée successivement à une borne du premier sous-ensemble ($E_1$), à l'entrée de l'amplificateur de charges (A) et à la masse, et le second condensateur ($C_{t2}$) ait une première borne connectée successivement à l'entrée de l'amplificateur de charges (A) et à la masse par le troisième commutateur ($I_3$) et une seconde borne connectée successivement avec la masse et avec une borne du second sous-ensemble ($E_2$) par le second commutateur ($I_2$).

## Claims

1. Method for improving the sensitivity and the signal to noise ratio of piezoelectric transducers including the combination of several sensors each formed of a sensitive piezoelectric element associated with electrodes and the application of signals generated by the combination of sensors to an elelctric charge amplifier (A) having a charge capacitor (C) connected for feedback, characterised in that the electrical capacity of the combination of sensors connected in parallel measurable at the input of the charge amplifier is reduced so as to reduce the amplification gain applied to the noise without changing the gain which is applied to the said signals, by connecting in successive cycles and in sequence a transfer capacitor ($C_t$) of a capacity very much less than the capacity of the charge capacitor (C) of the amplifier (A) with the parallel combination of sensors, to the input of the amplifier so as to transfer sequentially into the said charge capacitor (C) the electric charges accumulated by the sensors, in response to forces which are applied thereto, and to earth so as to discharge the transfer capacitor before any new connection to the said sensors.

2. Device for implementing the method as claimed in claim 1, characteriesed in that it incorporates at least one combination of piezoelectric sensors connected in parallel, at least one charge amplifier (A) associated with a charge capacitor (C), at least one transfer capacitor ($C_t$) of a capacity very much less than the capacity of the charge capacitor (C) and at least one electronic switch (I) controlled by synchronisation means for connecting a terminal of each transfer capacitor ($C_t$) sequentially with a combination of sensors in parallel, to the input of the said charge amplifier and to earth.

3. Device as claimed in claim 2, characterised in that the synchronisation means include a clock oscillator (H) emitting a switching signal whose frequency (F) is chosen as a function of the width of the useful pass band of the signals received by the said sensors, so as to provide filtering of the frequencies higher than those contained in the pass band.

4. Device as claimed in claim 2, characterised in that it comprises two transfer capacitors ($C_{t1}$, $C_{t2}$) each having a first terminal permanently connected to earth and two electronic switches ($I_1$ $I_2$), and in that the synchronisation means (H) are connected so as to apply a control signal to the switches ($I_1$ $I_2$) so that the second terminals of the two transfer capacitors ($C_{t1}$, $C_{t2}$) are connected sequentially and alternately to the combination of sensors in one case and to the input of the charge amplifier (A) in the other.

5. Device as claimed in claim 2, characterised in that the combination of sensors includes two subassemblies ($E_1$, $E_2$) of sensors connected in parallel, the two subassemblies being interconnected in series with their common terminals connected to earth, and in that it comprises two transfer capacitors ($C_{t1}$, $C_{t2}$) and three electronic switches ($I_1$, $I_2$, $I_3$) arranged so that the first capacitor ($C_{t1}$) has a first terminal permanently connected to earth and a second terminal connected successively to a terminal of the first subassembly ($E_1$), to the input of the charge amplifier (A) and to earth, and the second capacitor ($C_{t2}$) has a first terminal connected successively to the input of the charge amplifier (A) and to earth through the third switch ($I_3$) and a second terminal connected successively to earth and to a terminal of the second subassembly ($E_2$) through the second switch ($I_2$).

## Patentansprüche

1. Verfahren zur Verbesserung der Empfindlichkeit und des Signal-Rauschverhältnisses von piezo elektrischen Wandlern mit einer Kombination aus mehreren Sensoren, die jeweils aus einem piezoelektrisch empfindlichen, mit Elektroden zugeordneten Element bestehen, und der Zuführung der durch die Sensorenkombination geschalteten Ladekondensator (C) versehenen Verstärker (A) elektrischer Ladungen, dadurch gekennzeichnet, daß die am Eingang des Verstärkers elektrischer Ladungen meßbare elektrische Kapazität der Kombination paralleler Sensoren derart vermindert wird, daß der mit dem Rauschen verbundene Verstärkungsgewinn ohne Veränderung desselben bei den genannten Signalen verringert wird, indem in aufeinanderfolgenden Zyklen und in Folge ein Übertragungskondensator ($C_t$) mit im Vergleich zur Kapazität des Ladekondensators (C) des Verstärkers (A) sehr geringer Kapazität mit der Kombination paralleler Sensoren, mit dem Eingang des Verstärkers, so daß die durch die Sensoren aufgespeicherten elektrischen Ladungen aufeinanderfolgend in dem genannten Ladekondensator (C) in Beantwortung der ihnen auferlegten Zwänge übertragen werden, und mit Masse verbunden wird, so daß der Übertragungskondensator vor jeder neuen Verbindung mit den genannten Sensoren entladen wird.

2. Einrichtung zur Durchführung des Verfahrens nach Anspruch 1, dadurch gekennzeichnet, daß die mindestens eine Kombination von parallelen piezoelektrischen Sensoren, mindestens einen mit einem Ladekondensator (C) versehenen Verstärker (A) von Ladungen, wenigstens einen Übertragungskondensator ($C_t$) mit einer im Vergleich zur Kapazität des Ladekondensators (C) sehr geringen Kapazität und mindestens einen mittels Synchronisierungsmiteln gesteuerten elektronischen Umschalter (I) zur Verbindung eines Anschlusses jedes Übertragungskondensators ($C_t$) der Reihe nach mit einer Kombination paralleler Sensoren, mit dem Eingang des genannten Verstärkers von Ladungen und mit Masse aufweist.

3. Einrichtung nach Anspruch 2, dadurch gekennzeichnet, daß die einen Taktoszillator (H) aufweisenden Synchronisationsmittel ein Umschaltsignal abgeben, dessen Frequenz (F) in Funktion der Nutzdurchlaßbandbreite der von den genannten Sensoren empfangenen Signale gewählt wird, um eine

Filterung der Frequenzen zu realisieren, die höher sind als diejenigen, die im Durchlaßband enthalten sind.

4. Einrichtung nach Anspruch 2, dadurch gekennzeichnet, daß sie zwei Übertragungskondensatoren ($C_{t1}$, $C_{t2}$) aufweist, von denen jeder einen ersten, fortwährend mit Masse verbundenen Anschluß und zwei elektronische Umschalter ($I_1$, $I_2$) aufweist, und daß die Synchronisationsmittel (H) zur Zuführung eines Steuersignals an die Umschalter ($I_1$, $I_2$) derart geschaltet sind, daß die zweiten Anschlüsse der beiden Übertragungskondensatoren ($C_{t1}$, $C_{t2}$) in Folge und wechselweise mit der Sensorenkombination zum einen und mit dem Eingang des Verstärkers (A) von Ladungen zum anderen verbunden sind.

5. Einrichtung nach Anspruch 2, dadurch gekennzeichnet, daß die Kombination von Sensoren zwei Untergruppen ($E_1$, $E_2$) paralleler Sensoren aufweist, wobei die beiden untereinander in Reihe geschalteten Untergruppen mit ihren gemeinsamen Anschlüssen an Masse angeschlossen sind, daß zwei Übertragungskondensatoren ($C_{t1}$, $C_{t2}$) und drei elektronische Umschalter ($I_1$, $I_2$, $I_3$) vorgesehen sind, die so ausgelegt sind, daß der erste Kondensator ($C_{t1}$) einen ersten, fortwährend an Masse liegenden Anschluß und einen zweiten, aufeinanderfolgend mit einem Anschluß der ersten Untergruppe ($E_1$), mit dem Eingang der Verstärkers (A) von Ladungen und mit Masse verbundenen Anschluß hat und der zweite Kondensator ($C_{t2}$) einen ersten, aufeinanderfolgend mit dem Eingang des Verstärkers (A) von Ladungen und mit Masse mittels des dritten Umschalters ($I_3$) verbundenen Anschluß und einen zweiten, aufeinanderfolgend mit Masse und mit einem Anschluß der zweiten Untergruppe ($E_2$) mittels des zweiten Umschalters ($I_2$) verbundenen Anschluß hat.

PL.I.2

FIG.1

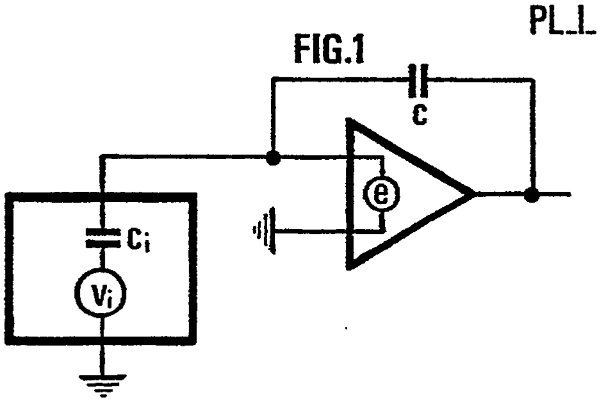


FIG.2

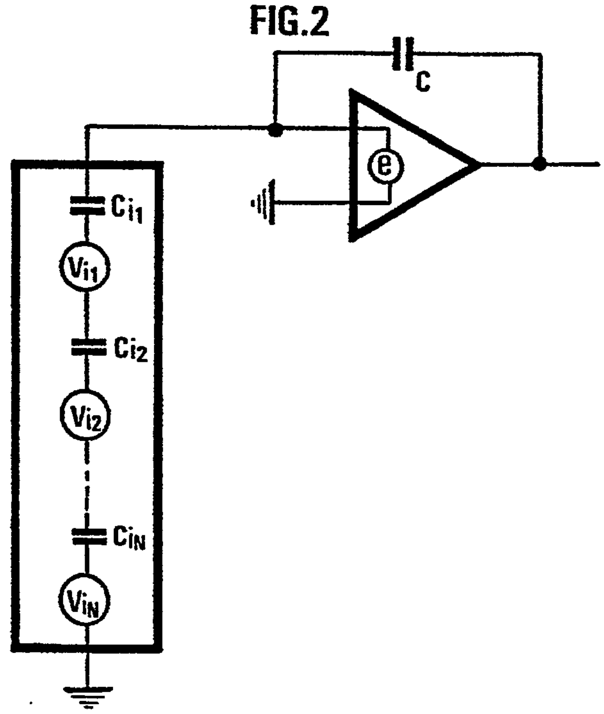


FIG.3

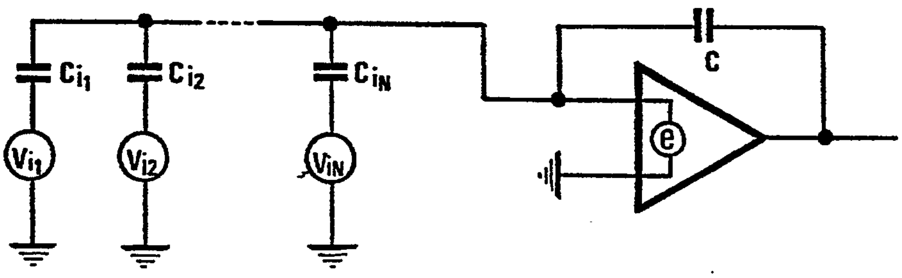


FIG.4

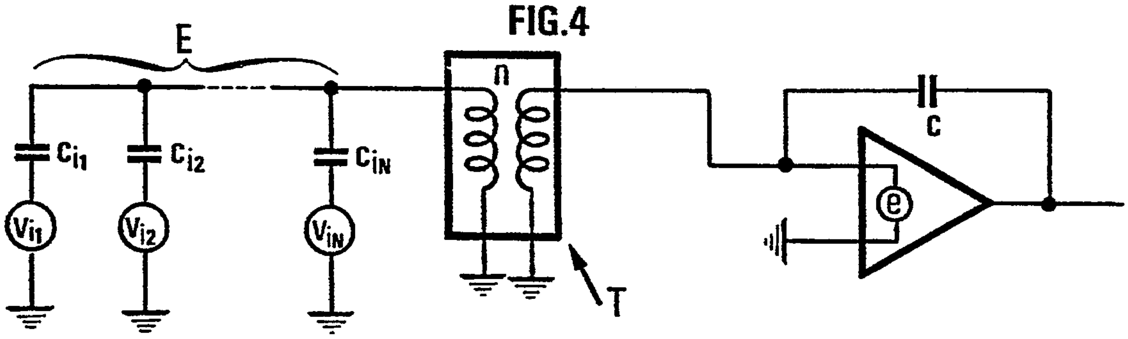


FIG.5

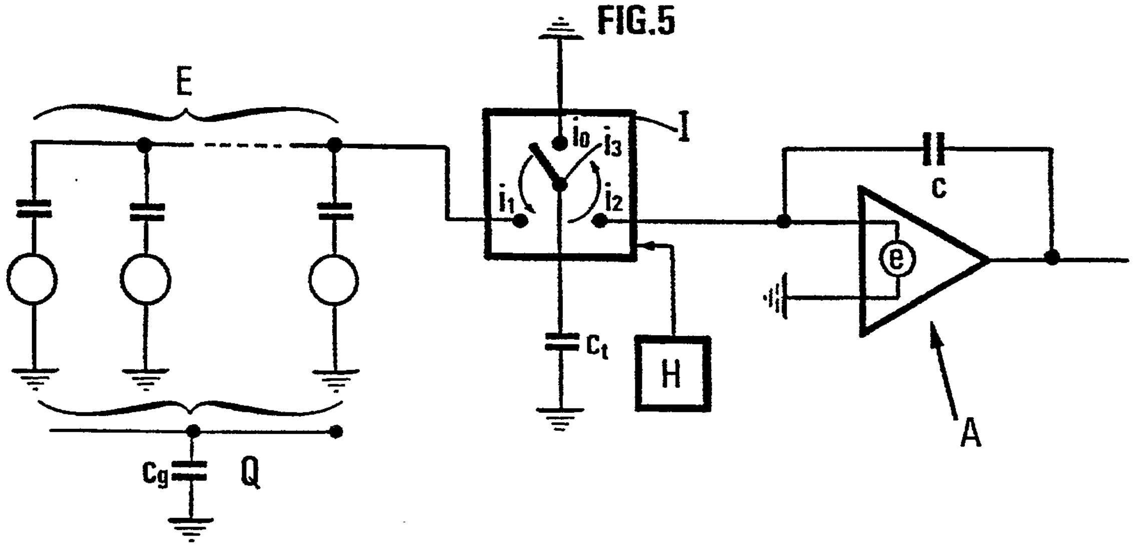

PL_II_2

FIG.6

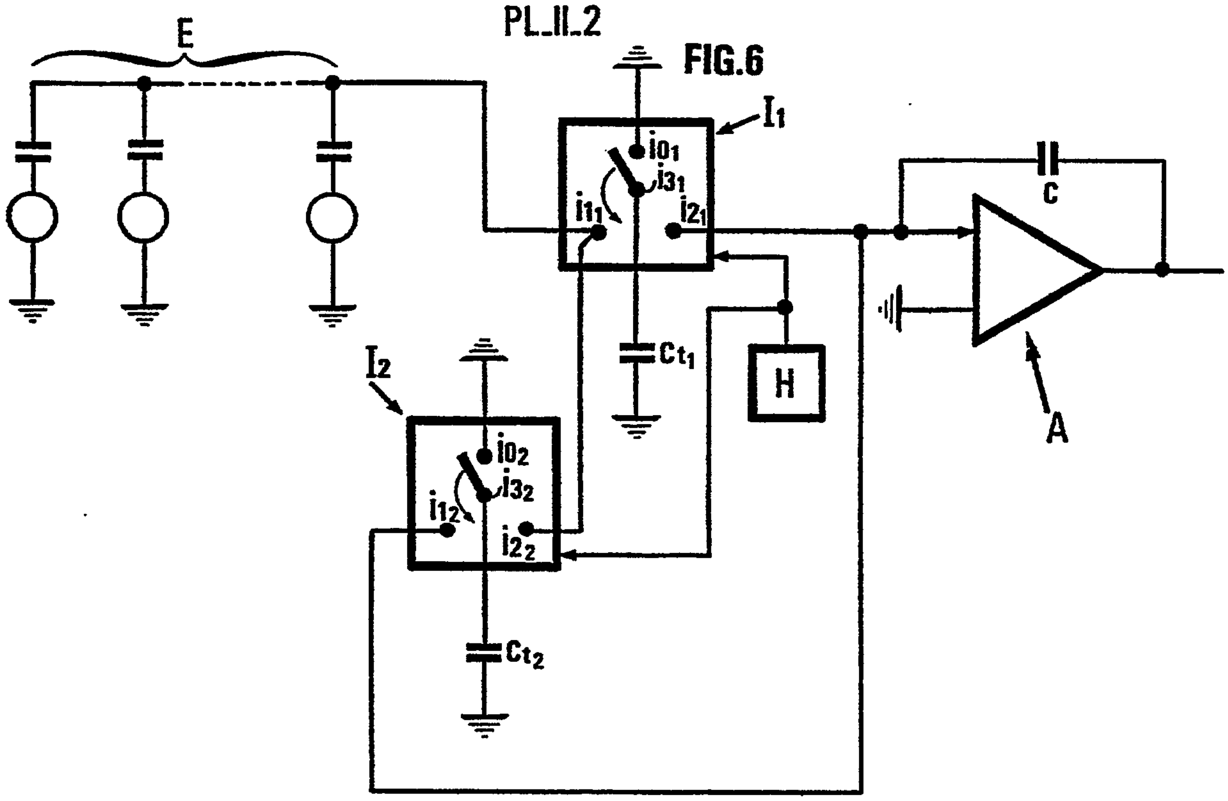


FIG.7